(19) Europäisches Patentamt
European Patent Office
Office européen des brevets

(11) EP 3 104 276 A1

(12) EUROPÄISCHE PATENTANMELDUNG

(43) Veröffentlichungstag:
**14.12.2016 Patentblatt 2016/50**

(21) Anmeldenummer: **15171102.5**

(22) Anmeldetag: **09.06.2015**

(51) Int Cl.:
***G06F 11/00*** *(2006.01)* ***G06F 11/07*** *(2006.01)*
***H04M 13/00*** *(2006.01)* ***H04L 1/12*** *(2006.01)*
***G06F 11/10*** *(2006.01)*

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA**

(71) Anmelder: **Siemens Aktiengesellschaft**
**80333 München (DE)**

(72) Erfinder:
- **Witte, Karl-Hermann**
**90482 Nürnberg (DE)**
- **Richter, Jan**
**91207 Lauf a. d. Pegnitz (DE)**
- **Walter, Maximilian**
**90408 Nürnberg (DE)**

# (54) VERFAHREN IN EINEM COMPUTERSYSTEM, COMPUTERPROGRAMM UND DATENVERARBEITUNGSANLAGE

(57) Die Erfindung betrifft ein Verfahren in einem Computersystem zur Umcodierung einer codierten Zwischenvariablen (z) in eine umcodierte Ergebnisvariable (z'), wobei ein Produkt durch eine Multiplikation einer Eingangskonstanten (A) mit einer zu codierenden Eingangsvariablen (xf) gebildet wird, und die codierte Zwischenvariable (z) zumindest mittels dieses Produkts gebildet wird und wobei ein multiplikatives Inverses ($A^{-1}$) von der Eingangskonstanten (A) bestimmt wird und das multiplikative Inverse ($A^{-1}$) auf die codierte Zwischenvariable (z) angewandt wird, so dass kein uncodiertes oder teilweise uncodiertes Zwischenresultat (R1,R2,R3) entsteht und/oder in welchem die potentiell in der codierten Zwischenvariablen (z) enthaltene Fehlerinformation nach wie vor erkennbar ist.

Weiterhin betrifft die Erfindung ein Computerprogramm sowie eine Datenverarbeitungsanlage.

100
z
Z*K1
R1
R1+K2
R2
R2+D'
R3
R3+K3*D
z'



Printed by Jouve, 75001 PARIS (FR)

## Beschreibung

Die Erfindung betrifft ein Verfahren in einem Computersystem zur Umcodierung einer codierten Zwischenvariablen in eine umcodierte Ergebnisvariable, ein Computerprogramm sowie eine Datenverarbeitungsanlage.

Funktional sichere Systeme werden zur Reduktion von Risiken für Gesundheit und Leben sowie zur Vermeidung von Umweltschäden eingesetzt. Neben der sicheren Erfassung und Kommunikation von Prozessinformationen erfordern diese eine sichere Verarbeitung, z.B. in speicherprogrammierbaren Steuerungen oder im Industrie-PC.

Bei der Verarbeitung funktional sicherer Daten müssen interne Fehler der Sicherheitsfunktion erkannt werden und eine Sicherheitsreaktion (z. B. Ausgabe sicherer Ersatzwerte) zur Folge haben. Dies wird klassischerweise durch Hardware-Replikation und Resultatvergleich erreicht. Eine Alternative ist die Codierung der Sicherheitsfunktion mittels arithmetischen Codes.

Eine häufig verwendete Codierung ist die ANBD-Kodierung bei der man eine Variable xf durch Multiplikation mit einer Eingangskonstanten A und durch Addition einer statischen, variablen-abhängigen Eingangssignatur B_x sowie einem dynamischen, zyklus-abhängigen Eingangsoperanden D codiert. Dabei werden alle numerischen Variablen nach einer Vorschrift der Form:

$$z = A*xf + B_x + D$$

codiert, und die arithmetischen Operationen (+,-,*,/, usw.) so angepasst, dass die Verarbeitung im codierten Bereich konsistente Resultate zum Ur-Bereich liefert (dabei können B oder D durchaus auch den Wert Null haben).

Nach dem gegenwärtigen Stand der Technik ist die Prüfung einer kodierten Variable sowie eine Umcodierung einer Variable von einem ANBD-Code in einen anderen A'NB'D'-Code nur über eine vollständige Decodierung der codierten Variablen möglich. Die Decodierung erfolgt mittels: xf = (z-B_x-D)/A. Die Prüfung einer codierten Variablen erfolgt durch: ((z-B_x-D) MOD A == 0). Das Resultat dieser Prüfung selbst ist eine uncodierte Variable, so dass die Prüfung auf einer unabhängigen Hardware durchgeführt werden muss. Wird das Verfahren zur Umcodierung verwendet, entsteht ein uncodiertes Zwischenresultat. Fehler, die sich auf dieses Zwischenresultat auswirken, können prinzipiell nicht erkannt werden. Außerdem geht die in der ursprünglichen codierten Variable enthaltene Fehlerinformation durch das Decodieren verloren, d.h. auch eine ungültig codierte Eingabe wird auf ein gültig codiertes Codewort abgebildet. Die Gültigkeit des Eingabeoperanden muss daher gesondert geprüft werden.

Eine erste Aufgabe der Erfindung ist die Angabe eines Verfahrens in einem Computersystem zur Umcodierung einer codierten Zwischenvariablen in eine umcodierte Ergebnisvariable, welches die oben genannten Probleme löst. Eine zweite Aufgabe liegt in der Angabe eines Computerprogramms mit einem Programmcode, welches diese Probleme löst. Eine weitere Aufgabe ist die Angabe einer Datenverarbeitungsanlage.

Die auf das Verfahren bezogene Aufgabe wird gelöst durch die Angabe eines Verfahren in einem Computersystem zur Umcodierung einer codierten Zwischenvariablen in eine umcodierte Ergebnisvariable, wobei ein Produkt durch eine Multiplikation einer Eingangskonstanten mit einer zu codierenden Eingangsvariablen gebildet wird, und die codierte Zwischenvariable zumindest mittels dieses Produkts gebildet wird, und wobei ein multiplikatives Inverses von dieser Eingangskonstanten bestimmt wird und das multiplikative Inverse auf die codierte Zwischenvariable angewandt wird, so dass kein uncodiertes oder teilweise uncodiertes Zwischenresultat entsteht und/oder in welchem die potentiell in der codierten Zwischenvariablen enthaltene Fehlerinformation nach wie vor erkennbar ist.

Die auf das Computerprogramm bezogene Aufgabe wird gelöst durch die Angabe eines Computerprogramms mit einem Programmcode zur Ausführung des oben beschriebenen Verfahrens, wenn das Computerprogramm auf einem Computer abläuft.

Die auf die Datenverarbeitungsanlage gerichtete Aufgabe wird gelöst durch die Angabe einer Datenverarbeitungsanlage zum Bereitstellen einer umcodierten Ergebnisvariablen aus einer codierten Zwischenvariable aufweisend:

- Ein Produkt durch eine Multiplikation einer Eingangskonstanten mit einer zu codierenden Eingangsvariablen,
- Eine aus zumindest mittels des Produkts codierten Zwischenvariablen,
- Ein multiplikatives Inverses von der Eingangskonstanten,
- Die umcodierte Ergebnisvariable durch Anwenden der multiplikativen Inversen auf die codierte Zwischenvariable, so dass kein uncodiertes oder teilweise uncodiertes Zwischenresultat entsteht und/oder in welchem die potentiell in der codierten Zwischenvariablen enthaltene Fehlerinformation nach wie vor erkennbar ist.

Bisher ist die Umcodierung nur über den Umweg einer vollständigen Decodierung der codierten Variablen möglich. Dies stellt jedoch auch einen hohen Risikofaktor dar. Die in der codierten Variablen enthaltene Fehlerinformation geht dabei verloren, d.h. auch eine ungültig codierte Eingabe wird auf ein gültiges Codewort abgebildet. Die geforderte sichere Verarbeitung kann nur durch zusätzliche Diagnosen, die zusätzlich und hardware-abhängig implementiert werden müssen, eingehalten werden und daher sehr kostenintensiv sind. Erfindungsgemäß wird dies nun vermieden.

Erfindungsgemäß wird nun die Umcodierung einer Zwischenvariablen, an Stelle durch eine Division, durch die Multiplikation der multiplikativen Inversen auf die codierte Zwischenvariable erzielt.

Die Verwendung der multiplikativen Inversen im vorliegenden Kontext ist kein naheliegendes Verfahren. Dies liegt insbesondere daran, dass normalerweise kein sinnvolles Resultat entsteht, wenn die Operation auf einen Dividenden angewendet wird, der nicht glatt durch den Divisor teilbar ist. Diese ansonsten unerwünschte Eigenschaft wird hier gezielt genutzt, um bei einem ungültig codierten Variablen auch ein ungültig codiertes Resultat zu erhalten.

Im Gegensatz zur herkömmlichen Umcodierung mittels Decodierung durch Division und anschließender Neucodierung entsteht kein uncodiertes oder teilweise uncodiertes Zwischenresultat. Deshalb kann das Verfahren auch innerhalb von codierten Operationen zum Einsatz kommen, obwohl dort keine unabhängige Prüfinstanz (redundante Hardware) zur Verfügung steht.

Diese Eigenschaft ist eine wichtige Voraussetzung für jede reine Implementierung von Coded Processing, das ohne zusätzliche Diagnose auskommt.

In den Unteransprüchen sind weitere vorteilhafte Maßnahmen aufgelistet, die beliebig miteinander kombiniert werden können, um weitere Vorteile zu erzielen.

Bevorzugt wird die codierte Zwischenvariable zumindest mittels Multiplikation einer Eingangskonstanten mit einer zu codierenden Eingangsvariablen gebildet, wobei ein multiplikatives Inverses von der Eingangskonstanten bestimmt wird und wobei ein Produkt aus der multiplikativen Inversen und einer umcodierten Ergebniskonstanten auf die codierte Zwischenvariable angewandt wird, so dass kein uncodiertes oder teilweise uncodiertes Zwischenresultat entsteht.

Bevorzugt können sowohl die Eingangssignatur und/oder der Eingangsoperand konstant Null sein, zudem können zusätzliche, andere Eingangssignaturen und/oder zusätzliche, andere Eingangsoperanden verwendet werden. Hierbei wird anschließend das multiplikative Inverse oder ein Produkt aus der multiplikativen Inversen und einer umcodierten Ergebniskonstanten auf die codierte Zwischenvariable in einem ersten Schritt angewandt.

Bevorzugt weist das multiplikative Inverse einen Restklassenring modular 2hochn ($\mathbb{Z}/2^n$) auf, wobei n die Bitbreite der codierten Zwischenvariablen darstellt, z.B. n=32 oder n=64. Das multiplikative Inverse kann z.B. mit Hilfe des erweiterten Euklid'schen Algorithmus berechnet werden. In einer bevorzugten Ausgestaltung werden arithmetische Überläufe ignoriert. Dadurch werden zeitaufwändige Rechenschritte eingespart.

In einer weiteren bevorzugten Ausgestaltung wird eine Zwischenvariable durch Multiplikation einer Eingangsvariablen mit einer Eingangskonstanten und durch Addition der statischen, variablen-abhängigen Eingangssignatur sowie des dynamischen, zyklus-abhängigen Eingangsoperanden gebildet, wobei die Zwischenvariable in eine umcodierte Ergebnisvariable mit einer umcodierten Ergebniskonstanten, einer umcodierten, statischen variablen-abhängigen Ergebnissignatur und einem umcodierten, dynamischen zyklus-abhängigen Ergebnisoperanden umcodiert, durch folgende Schritte:

- Erzeugen eines ersten Zwischenresultates durch Multiplikation der Zwischenvariablen mit einem ersten Parameter, wobei der erste Parameter eine Multiplikation der multiplikativen Inversen bezogen auf die Eingangskonstante und die umcodierte Ergebniskonstante ist,
- Erzeugen eines zweiten Zwischenresultates durch Addition eines zweiten Parameters zu dem ersten Zwischenresultat, wobei der zweite Parameter die umcodierte Ergebnissignatur abzüglich der Multiplikation der Eingangssignatur mit dem ersten Zwischenresultat ist,
- Erzeugen eines dritten Zwischenresultates durch Addition des umcodierten dynamischen, zyklus-abhängigen Ergebnisoperanden zu dem zweiten Zwischenresultat,
- Erzeugen der umcodierten Ergebnisvariablen durch Subtraktion des ersten Parameters vom dritten Zwischenresultat.

Es ist leicht zu erkennen, dass bei allen Zwischenresultaten die funktionale Eingangsvariable die Anforderungen an eine codierte Variable erfüllt. Beim Umcodieren entsteht daher kein uncodiertes Zwischenresultat, so dass ein eventuell neu hinzugekommener Fehler durch die Codierung erkannt wird.

In einer beispielhaften Ausgestaltung wird durch Anwenden der multiplikativen Inversen ein potentiell vorhandener Fehler in der Eingabe invertiert. Beispielhafterweise wird die umcodierte Ergebniskonstante durch Eins abzüglich der Eingangskonstanten multipliziert mit 2hochn bestimmt, d.h. $A'=(1-2^n*A)$, wobei n die Bitbreite ist. Vorteilhafterweise sind zudem die umcodierte statische variablen-abhängige Ergebnissignatur sowie der umcodierte, dynamische, zyklus-abhängige Ergebnisoperand frei wählbar. Hierdurch erfolgt die Umcodierung so, dass ein potentiell in der Eingabe vorhandener Fehlerwert invertiert wird. Kommt diese Codierung bei der Implementierung in codierten Negations-Operationen zum Einsatz, ergibt sich insgesamt eine Operation, die den Fehlerwert nicht invertiert, da sich die doppelte Negation des Fehlers ausgleicht. Dadurch kann vermieden werden, dass ein Fehler systematisch ausmaskiert wird.

Auch kann die umcodierte Ergebniskonstante so gebildet werden, dass die Eingangsvariable repliziert wird. Bevorzugt wird hierbei die Ergebniskonstante durch die Addition von 2hochn $2^n$ mit Eins gebildet, d.h. $A'=2^n+1$, so dass die Eingangsvariable repliziert wird. Zudem werden die umcodierte statische, variablen-abhängige Ergebnissignatur und der umcodierte dynamische, zyklus-abhängige Ergebnisoperand gleich Null gesetzt, d.h. B_x'=0 und D'=0. Diese Codierung ist nützlich, da auf derart codierte Operanden bitweise Boolesche Operationen wie z. B. AND, OR oder XOR direkt angewendet werden können.

Bevorzugt wird die Ergebniskonstante gleich Eins gesetzt und gleichzeitig die umcodierte statische, variablen-abhängige Ergebnissignatur und der umcodierte dynamische, zyklus-abhängige Ergebnisoperand gleich Null gesetzt, so dass die Umkodierung eine Dekodierung der codierten Zwischenvariablen ist, wobei die potentiell in der codierten Zwischenvariablen enthaltene Fehlerinformation nach wie vor erkennbar ist.

Weitere Merkmale, Eigenschaften und Vorteile der vorliegenden Erfindung ergeben sich aus der nachfolgenden Beschreibung unter Bezugnahme auf die beiliegende Figur. Darin zeigt schematisch:

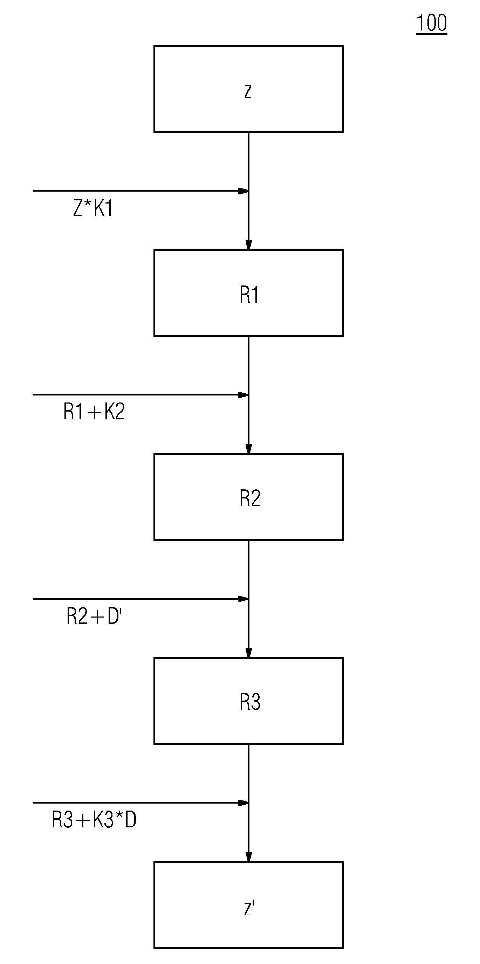

FIG 1 ein Flussdiagram 100 gemäß einem Ausführungsbeispiel der Erfindung.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

Die FIG zeigt die Umcodierung einer ANBD-codierten Zwischenvariablen z=(A*xf+B_x+D) in eine A'NB'D'-codierte Ergebnisvariable z'=(A'*xf+B_x'+D'). Dies erfolgt über folgende Rechenschritte:

Schritt 1: z*K1, mit einer Konstanten $K1=A^{-1}*A'$

Dies führt zu dem ersten Zwischenresultat R1:

$$A'*xf + A^{-1}*A'*B_x + A^{-1}*A'*D.$$

Schritt 2: R1+K2, mit einer Konstanten K2=B_x*K1+B_x'

Dies führt zu dem zweiten Zwischenresultat R2:

$$A'*xf + B_x' + A^{-1}*A'*D.$$

Schritt 3: R2+D'

Dies führt zu dem dritten Zwischenresultat R3:

$$A'*xf + B_x' + A^{-1}*A'*D + D'$$

Schritt 4: R3 + K3*D, mit der Konstanten $K3=-K1=-A^{-1}*A'$

Dies führt zu der umcodierten Ergebnisvariablen z':

$$z': A'*xf + B_x' + D'$$

Überläufe können dabei ggf. ignoriert werden. Der Wert $A^{-1}$ bezeichnet das multiplikative Inverse von A im Restklassenring $\mathbb{Z}$ modulo 2hochn ($\mathbb{Z}/2^n$), wobei n die Bitbreite der codierten Zwischenvariablen z darstellt (z.B. n=32 oder n=64). $A^{-1}$ kann z.B. mit Hilfe des erweiterten Euklid'schen Algorithmus berechnet werden. Wie daraus ersichtlich ist, sind alle Zwischenresultate R1, R2, R3 codiert. Es ist leicht zu erkennen, dass bei allen Zwischenresultaten R1, R2, R3 die funktionale Eingangsvariable xf mit einer Primzahl A bzw. A' multipliziert ist, dass stets Vielfache einer statischen Signatur B_x und/oder B_x' additiv enthalten sind, und dass stets Vielfache einer dynamischen Signatur D bzw. D' enthalten ist. Damit erfüllen alle Zwischenresultate R1,R2,R3 die Anforderungen an eine codierte Variable.

Im Gegensatz zur herkömmlichen Umcodierung mittels Decodierung durch Division und anschließender Neucodierung entsteht kein uncodiertes oder teilweise uncodiertes Zwischenresultat. Deshalb kann das Verfahren auch innerhalb von codierten Operationen zum Einsatz kommen, obwohl dort keine unabhängige Prüfinstanz (redundante Hardware) zur Verfügung steht. Diese Eigenschaft ist eine wichtige Voraussetzung für jede reine Implementierung von Coded Processing, das ohne zusätzliche Diagnose auskommt.

Erfindungsgemäß bleibt die Erkennbarkeit von Fehlern erhalten. Beim Umcodieren entsteht erfindungsgemäß kein uncodiertes Zwischenergebnis, so dass ein evtl. neu hinzugekommener Fehler durch die Codierung erkannt wird. Dies ist an mehreren kritischen Punkten erforderlich, z. B. beim Decodieren von Variablen mit gleichzeitiger Prüfung auf Fehler, bei der Implementierung von negierenden Operationen ohne Invertierung des Fehlersyndroms und der Implementierung von bitweisen Booleschen Operatoren.

Ein weiteres Beispiel ist die Umcodierung einer ANBD-codierten Zwischenvariable z=(A*xf+B_x+D+e) in eine A'NB'D'-codierte Variable z'=(A'*xf+B_x'+D') mit A'=1, B_x'=0 und D'=0 sowie einem Fehler e.

Dies führt zu der Ergebnisvariablen:

$$z':=xf + A^{-1}*e.$$

Hier erhält man als Umkodierung eine Decodierung des Operanden z. Im Unterschied zur klassischen Decodierung mittels Division ist jedoch eine ungültige Kodierung im Eingangsoperanden im Resultat erkennbar: genau in diesem Fall sind die höherwertigen Bits ungleich 0 (positive Zahlen und Null) bzw. ungleich -1 (negative Zahlen). Dies kann bei der Implementierung von Ergebnistreibern genutzt werden, indem ungültige Werte in den höherwertigen Bits dazu führen, dass die Prüfsumme von ausgehenden Telegrammen gezielt gestört und dadurch für den Empfänger als fehlerhaft erkennbar gemacht wird.

Ein weiteres Beispiel ist die Umcodierung einer ANBD-codierten Zwischenvariable z'=(A*xf+B_x+D+e) mit in eine A'NB'D'-codierte Variable z'=(A'*xf+B_x'+D'), wobei als $A'=(1-2^n*A)$ gewählt wird. Hierdurch erfolgt die Umcodierung so, dass ein potentiell vorhandener Fehlerwert invertiert wird. Kommt diese Kodierung bei der Implementierung in codierten Negations-Operationen zum Einsatz, ergibt sich insgesamt eine Operation, die den Fehlerwert nicht invertiert, da sich die doppelte Negation des Fehlers ausgleicht. Dadurch kann vermieden werden, dass ein Fehler systematisch ausmaskiert wird.

Ein zusätzliches Beispiel ist die Umcodierung einer ANBD-codierten Zwischenvariable z=(A*xf+B_x+D+e) mit in eine A'NB'D'-codierte Variable z'=(A'*xf+B_x'+D'), wobei als A'=2n+1, B_x'=0 und D'=0 gewählt wird. Durch Umcodierung entsteht dabei die Replikation des uncodierten Werts. Diese Kodierung ist nützlich, da auf sie auf bitweise Boolesche Operationen wie z. B. AND, OR oder XOR direkt angewendet werden kann.

Es ist zu beachten, dass in vielen Fällen D=D' gewählt wird. Das Verfahren vereinfacht sich dann zu:

```
z' = (z*K1 +K2)+K3*D
```

mit K1 =A-1*A', K2=-Bx*K1 +Bx', K3=-K1 +1.

## Patentansprüche

1. Verfahren in einem Computersystem zur Umcodierung einer codierten Zwischenvariablen (z) in eine umcodierte Ergebnisvariable (z'),
**dadurch gekennzeichnet, dass** ein Produkt durch eine Multiplikation einer Eingangskonstanten (A) mit einer zu codierenden Eingangsvariablen (xf) gebildet wird, und die codierte Zwischenvariable (z) zumindest mittels dieses Produkts gebildet wird und wobei ein multiplikatives Inverses ($A^{-1}$) von der Eingangskonstanten (A) bestimmt wird und das multiplikative Inverse ($A^{-1}$) auf die codierte Zwischenvariable (z) angewandt wird, so dass kein uncodiertes oder teilweise uncodiertes Zwischenresultat (R1,R2, R3) entsteht und/oder in welchem die potentiell in der codierten Zwischenvariablen (z) enthaltene Fehlerinformation nach wie vor erkennbar ist.

2. Verfahren in einem Computersystem zur Umcodierung einer codierten Zwischenvariablen (z) in eine umcodierte Ergebnisvariable (z') nach Anspruch 1,
**dadurch gekennzeichnet, dass** ein Produkt durch eine Multiplikation einer Eingangskonstanten (A) mit einer zu codierenden Eingangsvariablen (xf) gebildet wird, und die codierte Zwischenvariable (z) zumindest mittels dieses Produkts gebildet wird und wobei ein multiplikatives Inverses ($A^{-1}$) von der Eingangskonstanten (A) bestimmt wird und wobei ein Produkt aus der multiplikativen Inversen ($A^{-1}$) und einer umcodierten Ergebniskonstanten (A') auf die codierte Zwischenvariable (z) angewandt wird, so dass kein uncodiertes oder teilweise uncodiertes Zwischenresultat (R1,R2,R3) entsteht und/oder in welchem die potentiell in der codierten Zwischenvariablen (z) enthaltene Fehlerinformation nach wie vor erkennbar ist.

3. Verfahren zur Umcodierung einer codierten Zwischenvariablen (z) nach Anspruch 1 oder 2,
**dadurch gekennzeichnet, dass** die Eingangssignatur (B_x) und/oder der Eingangsoperand (D) konstant Null ist, und/oder zusätzliche, andere Eingangssignaturen und/oder zusätzliche, andere Eingangsoperanden verwendet werden.

4. Verfahren zur Umcodierung einer codierten Zwischenvariablen (z) nach einem der vorhergehenden Ansprüche,
**dadurch gekennzeichnet, dass** die multiplikative Inverse ($A^{-1}$) oder ein Produkt aus der multiplikativen Inversen ($A^{-1}$) und einer umcodierten Ergebniskonstanten (A') auf die codierte Zwischenvariable (z) in einem ersten Schritt angewandt wird.

5. Verfahren zur Umcodierung einer codierten Zwischenvariablen (z) nach einem der vorhergehenden Ansprüche,
**dadurch gekennzeichnet, dass** das multiplikative Inverse ($A^{-1}$) einen Restklassenring modulo 2hochn aufweist, wobei n die Bitbreite der codierten Zwischenvariablen (z) darstellt.

6. Verfahren zur Umcodierung einer codierten Zwischenvariablen (z) nach einem der vorhergehenden Ansprüche, **dadurch gekennzeichnet, dass** arithmetische Überläufe ignoriert werden.

7. Verfahren zur Umcodierung einer codierten Zwischenvariablen (z) nach einem der vorhergehenden Ansprüche,

   **dadurch gekennzeichnet, das** durch Anwenden der multiplikativen Inversen ($A^{-1}$) ein potentiell vorhandener Fehler (e) invertiert wird.

8. Verfahren zur Umcodierung einer codierten Zwischenvariablen (z) nach einem der Ansprüche 1-6,

**dadurch gekennzeichnet, dass** die Ergebniskonstanten (A') so gebildet wird, dass die Eingangsvariable (z) repliziert wird.

**9.** Verfahren zur Umcodierung einer codierten Zwischenvariablen (z) nach einem der vorhergehenden Ansprüche, **dadurch gekennzeichnet, dass** eine codierte Zwischenvariable (z) durch Multiplikation einer Eingangsvariablen (xf) mit einer Eingangskonstanten (A) und durch Addition der statischen, variablen-abhängigen Eingangssignatur (B_x) sowie des dynamischen, zyklus-abhängigen Eingangsoperanden (D) gebildet wird, wobei die Zwischenvariable (z) in eine umcodierte Ergebnisvariable (z') mit einer umcodierten Ergebniskonstanten (A'), einer umcodierten, statischen variablen-abhängigen Ergebnissignatur (B_x') und einem umcodierten, dynamischen zyklus-abhängigen Ergebnisoperanden (D') umcodiert wird, durch folgende Schritte:

- Erzeugen eines ersten Zwischenresultates (R1) durch Multiplikation der Zwischenvariablen (z) mit einem ersten Parameter (K1), wobei der erste Parameter (K1) eine Multiplikation der multiplikativen Inversen ($A^{-1}$) bezogen auf die Eingangskonstante (A) und die umcodierte Ergebniskonstante (A') ist,
- Erzeugen eines zweiten Zwischenresultats (R2) durch Addition eines zweiten Parameters (K2) zu dem ersten Zwischenresultat (R1), wobei der zweite Parameter (K2) die umcodierte Ergebnissignatur (B_x') abzüglich der Multiplikation der Eingangssignatur (B_x) mit dem ersten Zwischenresultat (R1) ist,
- Erzeugen eines dritten Zwischenresultats (R3) durch Addition des umcodierten dynamischen, zyklus-abhängigen Ergebnisoperanden (D') zu dem zweiten Zwischenresultat (R2),
- Erzeugen der umcodierten Ergebnisvariablen (z') durch Subtraktion des ersten Parameters (K1) vom dritten Zwischenresultat (R3).

**10.** Verfahren zur Umcodierung einer codierten Zwischenvariablen (z) nach Anspruch 9,
**dadurch gekennzeichnet, dass** die Ergebniskonstante (A') durch Eins abzüglich der Eingangskonstanten (A) multipliziert mit 2hochn gebildet wird, wobei n die Bitbreite der Zwischenvariablen (z) ist, so dass ein potentiell vorhandener Fehlerwert invertiert wird.

**11.** Verfahren zur Umcodierung einer codierten Zwischenvariablen (z) nach Anspruch 10,
**dadurch gekennzeichnet, dass** zudem die umcodierte statische variablen-abhängige Ergebnissignatur (B_x') sowie der umcodierte dynamische, zyklus-abhängige Ergebnisoperand (D') frei wählbar sind.

**12.** Verfahren zur Umcodierung einer codierten Zwischenvariablen (z) nach Anspruch 9,
**dadurch gekennzeichnet, dass** die Ergebniskonstante (A') durch die Addition von 2hochn mit Eins gebildet wird, so dass die Eingangsvariable (xf) repliziert wird.

**13.** Verfahren zur Umcodierung einer codierten Zwischenvariablen (z) nach Anspruch 10,
**dadurch gekennzeichnet, dass** zudem die umcodierte statische, variablen-abhängige Ergebnissignatur (B_x') und der umcodierte dynamische, zyklusabhängige Ergebnisoperand (D') gleich Null gesetzt werden.

**14.** Verfahren zur Umcodierung einer codierten Zwischenvariablen (z) nach Anspruch 9,
**dadurch gekennzeichnet, dass** die Ergebniskonstante (A') gleich Eins gesetzt wird und gleichzeitig die umcodierte statische, variablen-abhängige Ergebnissignatur (B_x') und der umcodierte dynamische, zyklus-abhängige Ergebnisoperand (D') gleich Null gesetzt werden, so dass die Umkodierung eine Dekodierung der codierten Zwischenvariablen (z) ist, wobei die potentiell in der codierten Zwischenvariablen (z) enthaltene Fehlerinformation nach wie vor erkennbar ist.

**15.** Computerprogramm mit einem Programmcode zur Durchführung aller Verfahrensschritt nach einem der vorhergehenden Ansprüchen 1-14, wenn das Computerprogramm in einem Computer ausgeführt wird.

**16.** Datenverarbeitungsanlage zum Bereitstellen einer umcodierten Ergebnisvariable (z') aus einer codierten Zwischenvariable (z) aufweisend:

- Ein Produkt durch eine Multiplikation einer Eingangskonstanten (A) mit einer zu codierenden Eingangsvariablen (xf),
- Eine aus zumindest mittels des Produkts codierten Zwischenvariablen (z),
- Ein multiplikatives Inverses ($A^{-1}$) von der Eingangskonstanten (A),
- Die umcodierten Ergebnisvariable (z') durch Anwenden der multiplikativen Inversen ($A^{-1}$) auf die codierte Zwischenvariable (z), so dass kein uncodiertes oder teilweise uncodiertes Zwischenresultat (R1,R2,R3) entsteht und/oder in welchem die potentiell in der codierten Zwischenvariablen (z) enthaltene Fehlerinformation nach wie vor erkennbar ist.

**17.** Datenverarbeitungsanlage zum Bereitstellen einer umcodierten Ergebnisvariable (z') aus einer codierten Zwischenvariable (z), wobei die codierte Zwischenvariable (z) durch Multiplikation einer Eingangsvariablen (xf) mit einer Eingangskonstanten (A) und durch Addition der statischen, variablen-abhängigen Eingangssignatur (B x) sowie des dynamischen, zyklus-abhängigen Eingangsoperanden (D) gebildet worden ist, nach Anspruch 16 aufweisend:

- Bereitstellen eines ersten Zwischenresultats (R1) durch Multiplikation der Zwischenvariablen (z') mit einem ersten Parameter (K1), wobei der erste Parameter (K1) eine Multiplikation der multiplikativen Inversen ($A^{-1}$) bezogen auf die Eingangskonstante (A) und der umcodierten Ergebniskonstanten (A') ist,
- Bereitstellen eines zweiten Zwischenresultats (R2) durch Addition eines zweiten Parameters (K2) zu dem ersten Zwischenresultat (R1), wobei der zweite Parameter (K2) die umcodierte Ergebnissignatur (B_x') abzüglich der Multiplikation der Eingangssignatur (B_x) mit dem ersten Zwischenresultat (R1) ist,
- Bereitstellen eines dritten Zwischenresultats (R3) durch Addition des umcodierten dynamischen, zyklus-abhängigen Ergebnisoperanden (D') zu dem zweiten Zwischenresultat (R2),
- Bereitstellen der umcodierten Ergebnisvariablen (z') durch Subtraktion des ersten Parameters (K1) vom dritten Zwischenresultat (R3).

100
Z
Z*K1
R1
R1+K2
R2
R2+D'
R3
R3+K3*D
Z'

Europäisches
Patentamt
European
Patent Office
Office européen
des brevets

# EUROPÄISCHER RECHERCHENBERICHT

Nummer der Anmeldung
EP 15 17 1102

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| X | MARTIN HOFFMANN ET AL: "Experiences with software-based soft-error mitigation using AN codes", SOFTWARE QUALITY JOURNAL, 22. November 2014 (2014-11-22), XP055209592, ISSN: 0963-9314, DOI: 10.1007/s11219-014-9260-4 * das ganze Dokument * ----- | 1-17 | INV. G06F11/00 G06F11/07 H04M13/00 H04L1/12 G06F11/10 |
| | | | RECHERCHIERTE SACHGEBIETE (IPC) |
| | | | G06F H04M H04L |

Der vorliegende Recherchenbericht wurde für alle Patentansprüche erstellt

| Recherchenort | Abschlußdatum der Recherche | Prüfer |
|---|---|---|
| Den Haag | 17. Dezember 2015 | Kielhöfer, Patrick |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

1
EPO FORM 1503 03.82 (P04C03)